# EUROPÄISCHE PATENTSCHRIFT

(11) **EP 2 393 953 B1**
(45) Veröffentlichungstag und Bekanntmachung des Hinweises auf die Patenterteilung: **03.04.2013**
(21) Anmeldenummer: 10702115.6
(22) Anmeldetag: 01.02.2010
(51) Int. Cl.: C23C 2/06, C23C 2/12, C23C 2/26

(54) **VERFAHREN ZUM HERSTELLEN EINES BESCHICHTETEN STAHLBAUTEILS DURCH WARMFORMEN UND DURCH WARMFORMEN HERGESTELLTES STAHLBAUTEIL**
METHOD FOR PRODUCING A COATED STEEL COMPONENT BY MEANS OF HOT FORMING AND STEEL COMPONENT PRODUCED BY MEANS OF HOT FORMING
PROCÉDÉ DE PRODUCTION D'UN COMPOSANT EN ACIER REVÊTU PAR FORMAGE À CHAUD ET COMPOSANT EN ACIER PRODUIT PAR FORMAGE À CHAUD

(30) Priorität: 06.02.2009 DE 102009007909
(43) Veröffentlichungstag der Anmeldung: 14.12.2011
(73) Patentinhaber: ThyssenKrupp Steel Europe AG, 47166 Duisburg (DE)
(72) Erfinder: LUPP, Barbara, 44319 Dortmund (DE); ALBERS, Ansgar, 45665 Recklinghausen (DE); HASENFUSS, Sabine, 70567 Stuttgart (DE); KIMPEL, Matthias, 58332 Schwelm (DE); MEURER, Manfred, 47495 Rheinberg (DE); WARNECKE, Wilhelm, 46499 Hamminkeln (DE); STEINHORST, Michael, 45357 Essen (DE)
(74) Vertreter: Cohausz & Florack
(86) Internationale Anmeldenummer: PCT/EP2010/051175
(87) Internationale Veröffentlichungsnummer: WO 2010/089273

(56) Entgegenhaltungen:
- EP-A1- 0 427 389
- EP-A1- 2 088 223
- DE-B3-102006 039 307
- JP-A- 57 200 548
- JP-A- 2005 290 552
- US-A1- 2008 271 823

## Beschreibung

Die Erfindung betrifft ein Verfahren zum Herstellen eines mit einer metallischen, vor Korrosion, insbesondere durch eine kathodische Schutzwirkung, schützenden Überzug versehenen Stahlbauteils durch Warmformen eines aus einem legierten, insbesondere niedrig legierten Vergütungsstahl erzeugten Stahlflachprodukts.

Darüber hinaus betrifft die Erfindung ein durch Warmformen eines Stahlflachproduktes erzeugtes, mit einer metallischen, vor Korrosion, insbesondere durch eine kathodische Schutzwirkung, schützenden Korrosionsschutzbeschichtung versehenes Stahlbauteil.

Wenn hier von Stahlflachprodukten die Rede ist, so sind damit Stahlbänder, Stahlbleche oder daraus gewonnene Platinen sowie das Stahlsubstrat des aus solchen Bändern, Blechen oder Platinen gewonnenen Stahlbauteils gemeint.

An die Steifigkeit und Festigkeit von Bauteilen werden gerade im Fahrzeugbau zunehmend hohe Anforderungen gestellt. Gleichzeitig werden jedoch im Interesse einer Optimierung des für den Antrieb des jeweiligen Fahrzeugs benötigten Energieverbrauchs ein möglichst geringes Karosseriegewicht und entsprechend geringe Materialdicken angestrebt. Erfüllt werden können diese auf den ersten Blick widersprüchlichen Anforderungen durch hochfeste und höchstfeste Stahlwerkstoffe, welche unter Anwendung geeigneter Verfahrensschritte die Herstellung von Bauteilen mit sehr hoher Festigkeit bei geringer Materialdicke erlauben.

Ein Verfahren, dass die Herstellung entsprechend hochfester und gleichzeitig dünnwandiger Stahlbauteile erlaubt, ist das Warmpresshärten. Beim Warmpresshärten wird zunächst aus einem Stahlband eine Platine geschnitten. Diese Platine wird dann auf eine Warmformtemperatur erwärmt, die in der Regel oberhalb der Ar3-Temperatur des jeweils verarbeiteten Stahlwerkstoffs liegt. Die so erwärmte Platine wird dann im warmen Zustand in ein Umformwerkzeug gelegt und darin in die gewünschte Bauteilform gebracht. Anschließend bzw. unterdessen erfolgt eine Abkühlung des geformten Bauteils, bei der im verarbeiteten Stahl ein Vergütungs- bzw. Härtegefüge entsteht.

Für das Pressformhärten kommen niedrig legierte Stähle in Frage. Allerdings sind diese Stähle empfindlich gegen korrosive Angriffe, denen sie insbesondere dann ausgesetzt sind, wenn sie für den Bau von Fahrzeugkarosserien verwendet werden.

In jüngerer Zeit sind verschiedene Versuche gemacht worden, die Vorteile des Warmumformens von hochfesten, für das Warmpresshärten geeigneten Stählen gerade auch für diese Einsatzbereiche nutzbar machen. Als Vorreiter dieser Entwicklung ist der in der EP 0 971 044 B1 beschriebene Stand der Technik zu nennen. Gemäß diesem bekannten Verfahren wird ein warmgewalztes Stahlblech verarbeitet, welches neben Eisen und unvermeidbaren Verunreinigungen in (Gew.-%) zwischen 0,15 - 0,5 % C, zwischen 0,5 - 3 % Mn, zwischen 0,1 - 0,5 % Si, zwischen 0,01 - 1% Cr, weniger als 0,2% Ti, jeweils weniger als 0,1% Al und P, weniger als 0,05 S sowie zwischen 0,0005 - 0,08 % B enthält. Der entsprechend dieser Vorschrift zusammengesetzte Stahl ist in der Praxis unter der Bezeichnung 22MnB5 bekannt.

Das derart zusammengesetzte Stahlband wird gemäß der EP 0 971 044 B1 mit einer Beschichtung versehen, die auf Aluminium oder einer Aluminiumlegierung basiert. Insbesondere handelt es sich bei dieser Beschichtung um einen AlSi-Überzug, der Gehalte an Fe aufweist. Das derart beschichtete Stahlband wird auf eine Temperatur von mehr als 750 °C erwärmt, zu einem Bauteil geformt und anschließend mit einer Abkühlgeschwindigkeit abgekühlt, unter der sich ein Härtegefüge ausbildet.

Das in der aus der EP 0 971 044 B1 bekannten Weise erzeugte Stahlbauteil weist neben guten Festigkeitseigenschaften eine grundsätzlich gute Beständigkeit gegen Korrosion auf. Gleichzeitig lassen sich aus den gemäß diesem Stand der Technik zur Verfügung gestellten Stahlblechen in nur einem einzigen Warmumformschritt Stahlbauteile erzeugen, ohne dass es zu einer Beschädigung der Al-Beschichtung kommt.

Den in der bekannten Weise verarbeiteten, mit einem Albasierten Überzug versehenen Stählen fehlt eine wesentliche Eigenschaft, die den Stahl bei Verletzung kathodisch gegen Korrosion schützt. Diese Empfindlichkeit erweist sich insbesondere beim Einsatz der nach dem bekannten Verfahren verarbeiteten Stähle im Bereich von Karosserie für Automobile als problematisch.

Um diesen Nachteil zu vermeiden, ist in der WO 2005/021820 A1, der WO 2005/021821 A1 und der WO 2005/021822 A1 jeweils vorgeschlagen worden, anstelle eines A1-basierten Überzugs eine auf Zink basierende Beschichtung auf das Stahlsubstrat aufzubringen. Aus derart beschichteten Stahlflachprodukten erzeugte Blechbauteile weisen zwar einen kathodischen Korrosionsschutz auf. Dazu muss allerdings in Kauf genommen werden, dass die Verformung des jeweiligen Stahlflachprodukts zu dem Bauteil in mindestens zwei Stufen erfolgen muss, wobei die erste Stufe eine Kaltverformung ist, in der der weitaus größte Teil der Formgebung erfolgt, und im Zuge der Warmverformungsstufe lediglich noch eine Kalibrierung des Bauteils mit anschließender Abschreckung möglich ist. Dies führt zu einer nur begrenzten wirtschaftlichen Nutzbarkeit dieses bekannten Prozesses.

Ein weiterer Versuch wird in der JP 57 200 548 angegeben.

Ein alternativer Versuch, aus Stählen der in der EP 0 971 044 B1 beschriebenen Art erzeugte Bauteile effektiver für den Einsatz im Fahrzeugkarosseriebau verwenden zu können, ist aus der DE 103 33 166 A1 beschrieben. Gemäß dem aus dieser Offenlegungsschrift bekannten Verfahren wird ein Stahlbauteil in einer aus der EP 0 971 044 B1 bekannten Weise erzeugt und anschließend mit einer zusätzlichen Zinkschicht überzogen. Durch diese nachträgliche Stückverzinkung ist zwar das Problem des kathodischen Korrosionsschutzes gelöst, jedoch muss dazu ein zusätzlicher nachträglicher Beschichtungsschritt in Kauf genommen werden, der nicht nur zu einem erhöhten Zeitaufwand bei der Herstellung von Karosseriebauteilen, sondern auch zu einem erhöhten Kostenaufwand führt.

Vor dem Hintergrund des voranstehend erläuterten Standes der Technik lag der Erfindung die Aufgabe zugrunde, ein wirtschaftliches Verfahren zur Herstellung von hochfesten Stahlbauteilen anzugeben, bei dem einerseits optimiertes Verformungsverhalten des Überzugs während des Warmpressformens des jeweiligen Stahlflachprodukts gewährleistet ist und bei dem andererseits die erhaltenen Stahlbauteile einen optimierten Korrosionsschutz besitzen, der sie insbesondere für den Einsatz in Automobilkarosserien geeignet macht. Darüber hinaus sollte ein entsprechend beschaffenes Stahlbauteil geschaffen werden.

In Bezug auf das Verfahren ist diese Aufgabe erfindungsgemäß dadurch gelöst worden, dass bei der Herstellung eines Stahlbauteils die in Anspruch 1 angegebenen Arbeitsschritte durchlaufen werden. Vorteilhafte Ausgestaltungen dieses Verfahrens sind in den auf Anspruch 1 rückbezogenen Ansprüchen angegeben.

In Bezug auf das Stahlbauteil ist diese Aufgabe erfindungsgemäß dadurch gelöst worden, dass ein solches Stahlbauteil gemäß Anspruch 25 ausgebildet ist. Vorteilhafte Ausgestaltungen dieses Bauteils sind in den von Anspruch 25 abhängigen Ansprüchen genannt.

Gemäß der Erfindung wird auf einem aus einem niedrig legierten Vergütungsstahl erzeugten Stahlflachprodukt eine metallische Beschichtung erzeugt, die aus drei in drei Verfahrensschritten nacheinander aufgebrachten Schichten gebildet ist. Bei dem Vergütungsstahl, aus dem das Stahlflachprodukt hergestellt ist, kann es sich beispielsweise um einen Mangan-Bor-Stahl handeln, wie er bereits im Stand der Technik vielfach eingesetzt wird.

Gemäß der Erfindung wird im ersten Arbeitsschritt a) das aus dem geeignet zusammengesetzten Vergütungsstahl erzeugte Stahlflachprodukt mit einem Al-Überzug beschichtet, der mindestens 85 Gew.-% Al, insbesondere 90 Gew.-%, enthält, wobei zusätzlich Gehalte von bis zu 15 Gew.-% in dem erfindungsgemäß aufgetragenen Al-Überzug vorhanden sein können. Typische Varianten der erfindungsgemäß aufgetragenen A1-Beschichtung sind ein fast vollständig aus A1 bestehender Überzug oder eine AlSi-Variante, bei der der Si-Gehalt des aufgetragenen AlSi-Überzugs 5 - 12 Gew.-% Si, insbesondere 8 - 12 Gew.-%, beträgt.

Anschließend wird auf diesen A1-Überzug ein Zn-Überzug aufgetragen, der zu mindestens 90 Gew.-%, insbesondere zu 95 Gew.-%, aus Zink besteht (Arbeitsschritt b)).

In einem Arbeitsschritt c) wird abschließend das mit dem Al-Überzug und dem darauf liegenden Zn-Überzug versehene Stahlflachprodukt mit einer Deckschicht beschichtet, deren Hauptbestandteil mindestens ein metallisches Salz der Phosphorsäure oder der Diphosphorsäure ist und die zusätzlich Gehalte von bis zu 45 % eines Verhältnisses Al:Zn, wobei Al an diesem Verhältnis 0,1 - 99,9 Gew.-% und Zn den jeweiligen Rest einnimmt, oder Verbindungen von Al und Zn sowie wahlweise Metalloxide, Metallhydroxide und/oder Schwefelverbindungen enthalten kann. Zusätzlich können bis zu 2 Gew.-% Sulfide der im Phosphat vorhandenen Metallionen vorhanden sein.

Bevor das Stahlflachprodukt der Weiterverarbeitung zugeführt wird, ist nach der Beschichtung auf einem in erfindungsgemäßer Weise beschichteten Stahlflachprodukt somit ein Überzug vorhanden, der eine zu mindestens 85 % aus Aluminium bestehende Grundschicht, eine im Wesentlichen aus Zink bestehende, auf der Grundschicht aufliegende Zwischenschicht und eine darauf aufgetragene Deckschicht aufweist, die zum überwiegenden Teil aus einem Metallphosphat gebildet ist.

Das in der auf die Zn-Schicht aufgetragenen Deckschicht in Form von einem metallischen Salz der Phosphor- oder Diphosphorsäure vorhandene Metallphosphat kann grundsätzlich mit einem Metall aus der Gruppe "Cu, Mo, Fe, Mn, Sb, Zn, Ti, Ni, Co, V, Mg, Bi, Be, Al, Ce, Ba, Sr, Na, K, Ge, Ga, Ca, Cr, In, Sn" gebildet sein, wobei die Elemente "Zn, Al, Ni, Mn, Mg, Bi, Cu, Si, Mo" besonders in Frage kommen. Besonders gute Eigenschaften der Deckschicht stellen sich ein, wenn das Metallphosphat mit einem der Gruppe "Zn, Fe, Mn, Ni, Mo, Mg" angehörenden Metall gebildet ist. Sofern sich dies als zweckmäßig erweist, können in der Deckschicht auch zwei oder mehr Metallphosphate in Kombination miteinander enthalten sein.

Vor der Warmumformung zum jeweiligen Bauteil wird das derart mindestens dreischichtig beschichtete Stahlflachprodukt in einem Arbeitsschritt d) bei einer mindestens 750 °C betragenden Wärmebehandlungstemperatur wärmebehandelt. Im Zuge dieser Wärmebehandlung stellt sich in Folge von während der Wärmebehandlung ablaufenden Diffusionsvorgängen ein metallischer Überzug ein, der durch eine typischerweise überwiegend aus AlFeZnSi bestehende, auf dem Stahlsubstrat aufliegende Grundschicht besteht, an der Al den größten Anteil hat, jedoch auch Fe, Zn und Si als wesentliche Bestandteile hervortreten.

Auf der nach der Wärmebehandlung erhaltenen Grundschicht des Überzugs liegt eine typischerweise überwiegend aus ZnAl(Fe,Si) bestehende Zwischenschicht.

Die Zwischenschicht ist wiederum durch eine Deckschicht abgedeckt, die aus Zink und amorphen Phosphaten oder deren thermischen Spaltprodukten besteht, wobei typischerweise 0,1 - 45 Gew.-% Zn in der vom Stahlflachprodukt abgewandten Oberfläche sowie kristalline Restanteile an Phosphaten enthalten sind.

Beim fertig geformten Bauteil enthält die Deckschicht Zink, der aus der Zwischenschicht in die Deckschicht eindiffundiert ist und dort ZnO gebildet hat. Dementsprechend besteht die Deckschicht in der Praxis insbesondere überwiegend aus amorphen und kristallinen Diphosphaten und Zink- und/oder Aluminiumoxid.

Enthält die im Arbeitsschritt c) aufgebrachte Deckschicht als Metallphosphat ein Zn-Phosphat (Zn₃(PO₄)₂), ein Fe-Phosphat oder ein Mn-Phosphat, so besteht nach der Wärmebehandlung (Arbeitsschritt d)) die am für die Warmverformung vorbereiteten Stahlflachprodukt vorhandene Deckschicht zum überwiegenden Teil aus ZnO, Zn, Zn3(PO4)2, Fe, FeO, Al. Diese sind üblicherweise kristallin ausgebildet, können aber auch abhängig vom Temperaturprofil der Wärmebehandlung amorphe Strukturen besitzen.

Das wärmebehandelte Stahlflachprodukt wird erforderlichenfalls in einem gesonderten Arbeitsschritt e) auf die Warmformtemperatur erwärmt, ausgehend von der die anschließende Warmformgebung durchgeführt wird. Die Warmformtemperatur liegt ebenfalls bei mindestens 750 °C. Dabei gilt sowohl für die Wärmebehandlungstemperatur als auch für die Warmformtemperatur, dass unter den in der praktischen Anwendung relevanten Bedingungen typischerweise im Bereich von 800 - 950 °C, insbesondere 800 - 910 °C oder 820 - 890 °C, liegen.

Die erfindungsgemäß vorgesehene Dauer der Wärmebehandlung liegt abhängig von der jeweils zur Verfügung stehenden Ofentechnik und der Geometrie des Stahlflachprodukts im Bereich von 30 - 720 Sekunden, wobei sich eine Wärmebehandlungsdauer von 60 - 360 Sekunden als besonders praxisgerecht herausgestellt hat.

Eine besonders kostengünstig und mit vermindertem apparativen Aufwand durchführbare Variante der Erfindung ist dadurch gekennzeichnet, dass die Wärmebehandlung (Arbeitsschritt d)) und die Erwärmung des Stahlflachproduktes auf die Warmformtemperatur (Arbeitsschritt e)) zusammengefasst in einem gemeinsamen Arbeitsschritt durchgeführt werden. Dies gilt insbesondere unter Berücksichtigung des Umstandes, dass sich der erfindungsgemäß auf dem Stahlflachprodukt vor dem Warmformen erzeugte Überzug bei einer Wärmebehandlung einstellt, die in dem Temperaturbereich durchgeführt wird, in dem auch die Warmformtemperatur typischerweise liegt.

Das auf die Warmformtemperatur erwärmte Stahlflachprodukt wird in einem weiteren Arbeitsschritt f) in an sich bekannter Weise zum jeweiligen Bauteil warmgeformt.

Das durch das Warmformen erhaltene Stahlbauteil wird abschließend so auf eine Art und Weise abgekühlt, durch die sichergestellt ist, dass sich in dem Bauteil das jeweils angestrebte Vergütungs- bzw. Härtegefüge ergibt.

Bei den voranstehend aufgezählten Arbeitsschritten handelt es sich um diejenigen Maßnahmen, die mindestens notwendig sind, um den erfindungsgemäß erzielten Erfolg zu erreichen. Selbstverständlich können zusätzliche Schritte vorgesehen werden, wenn dies sich aus produktionstechnischer Sicht für notwendig erweist.

So kann dem Erwärmen auf die Warmformtemperatur beispielsweise ein Zerteilen des zuvor als Band vorliegenden in der erfindungsgemäßen Weise zweischichtig überzogenen Flachprodukts zu Platinen vorausgehen. Darüber hinaus kann den einzelnen Beschichtungsschritten jeweils eine Reinigung der Oberfläche des Stahlflachproduktes bzw. der darauf aufgetragenen Beschichtung vorangehen.

Überraschend hat sich zunächst gezeigt, dass das in erfindungsgemäßer Weise beschichtete Stahlflachprodukt sich problemlos zu einem Stahlbauteil umformen lässt. So erwies sich erfindungsgemäß beschichtetes Stahlflachprodukt sowohl für eine direkte, d. h als einstufiger Arbeitsschritt ohne vorhergehende Kaltverformung durchgeführte Warmformgebung, als auch für eine indirekte, d. h. mindestens zweistufige, durch eine Aufeinanderfolge von Kaltverformung und Warmverformung gekennzeichnete Formgebung geeignet. Nach der jeweils durchgeführten Warmformgebung liegt bei einem erfindungsgemäßen Stahlbauteil eine zinklegierte Oberfläche mit einem Zink-Gehalt von mindesten 60 Gew.-%, insbesondere von mindestens 80 Gew.-%, vor. Daraus resultiert ein kathodischer Korrosionsschutz, der elektrochemisch eindeutig nachweisbar ist. So konnte im beschleunigten Korrosionstest (Salzsprühnebeltest) nachgewiesen werden, dass erfindungsgemäß erzeugte Überzüge eine Beständigkeit gegen Korrosion besitzen, die mit reinen Zinküberzügen mindestens vergleichbar sind.

Aus dem Umstand, dass bis zu 30 % Al in der Zwischenschicht des erfindungsgemäß erhaltenen Stahlbauteils vorhanden sein können, ergeben sich zusätzliche Vorteile in Bezug auf den Korrosionsschutz. Die einen hohen Anteil an Al aufweisende, zwischen der Zn-dominierten Zwischenschicht und der dem jeweiligen Stahlsubstrat angeordneten Grundschicht des erfindungsgemäß erzeugten metallischen Gesamtüberzugs schützt diesen vor einer übermäßigen Zink- und Eisendiffusion während der Wärmebehandlung bei den erfindungsgemäß gewählten Wärmebehandlungs- und Warmformtemperaturen. Als Vorteile der Sperrwirkung der Grundschicht ist zum einen eine verzögerte Rotrostbildung an der Oberfläche zu nennen. Zum anderen verhindert die Grundschicht, dass Zink auf die Korngrenzen des Stahlsubstrats gelangen kann, was die Gefahr einer Rissbildung bei der Warmumformung zur Folge hätte. Die Al-Fe-Zn-Si-haltige Grundschicht des erfindungsgemäß erzeugten Gesamtüberzuges schützt das Stahlsubstrat darüber hinaus besonders wirksam gegen eine Oxidation mit dem Sauerstoff der Umgebung.

Bei der Warmformgebung kommt der auf erfindungsgemäße Weise auf dem Stahlflachprodukt erzeugten Deckschicht eine besondere Bedeutung zu. Bei der Warmformgebung bewirkt diese im Sinne einer "Funktionsschicht" eine Trennung zwischen den unter ihr liegenden Schichten des erfindungsgemäß erzeugten Überzugs und den Oberflächen des Werkzeugs, mit denen das Stahlfachprodukt bei seiner Warmverformung zu dem Stahlbauteil in Berührung kommt. Auf diese Weise verhindert sie sicher einen übermäßigen Abrieb von Überzugsmaterial im Warmformwerkzeug und schließt so lokale Verschweißungen zwischen dem Bauteil und dem Werkzeug aus, durch die andernfalls das Herstellungsergebnis verschlechtert oder das Werkzeug beschädigt werden könnten.

Des Weiteren - und dies war besonders überraschend - verringert die am erfindungsgemäß verarbeiteten Stahlflachprodukt bei seinem Eintritt in das Warmformwerkzeug vorhandene Deckschicht besonders effektiv die Gefahr der Entstehung von Rissen, die andernfalls im Zuge der Warmformung in der Überzugsschicht entstehen könnten und deren korrosionsschützende Wirkung beeinträchtigen würden.

Das erfindungsgemäß erzeugte Stahlbauteil weist dementsprechend eine gegenüber konventionell erzeugten Bauteilen erhöhte Korrosionsbeständigkeit sowie signifikant verbesserte Reibeigenschaften bei einer gegebenenfalls nachfolgend an ihm durchgeführten Kaltverformung auf. Darüber hinaus gewährleistet die an dem Stahlbauteil erfindungsgemäß vorhandene Deckschicht eine besonders gute Lackhaftung. Des Weiteren besitzt der an einem erfindungsgemäß erzeugten Stahlbauteil vorhandene Überzug eine gegenüber dem Stand der Technik deutlich verbesserte Eignung für eine Widerstandspunktschweißung.

Mit der erfindungsgemäßen Vorgehensweise steht somit eine besonders wirtschaftlich durchführbare Möglichkeit der Herstellung von optimiert korrosionsgeschützten Bauteilen aus hochfesten warmpressformbaren Stählen zur Verfügung, die ein für ihre Weiterverarbeitung optimiertes Eigenschaftsprofil besitzen.

Ein in erfindungsgemäßer Weise beschaffenes Stahlbauteil trägt den voranstehend zusammengefassten Erkenntnissen folgend eine metallische Beschichtung, die durch eine auf dem Stahlflachprodukt aufliegende Grundschicht, eine auf der Grundschicht liegende Zwischenschicht und eine auf der Zwischenschicht liegende Deckschicht gebildet ist, wobei die Grundschicht mindestens 30 Gew.-% Al, mindestens 20 Gew.-% Fe, mindestens 3 Gew.-% Si und höchstens 30 Gew.-% Zn enthält, wobei die Deckschicht mindestens 60 Gew.-% Zn, mindestens 5 Gew.-% Al, bis zu 10 Gew.-% Fe und bis zu 10 Gew.-% Si und wobei die Deckschicht mindestens 8 Gew.-% Zn sowie ZnO, P und Al enthält, wobei der P-Gehalt höchstens 1 Gew.-% aufweist und der Hauptbestandteil der Deckschicht ZnO ist. In der Praxis zeigt sich dabei, dass die Deckschicht regelmäßig überwiegend aus amorphen und kristallinen Diphosphaten und Zink- und/oder Aluminiumoxid besteht.

Besonders wirtschaftlich bei gleichzeitig optimalem Beschichtungsergebnis kann der Al-Überzug durch Feueraluminieren als erste Überzugsschicht auf das jeweilige Stahlflachprodukt aufgebracht werden.

Der Zn-Überzug kann dann ebenfalls besonders wirtschaftlich in vergleichbarer, an sich bekannter und in der Praxis bewährten Weise durch ein Feuerverzinken auf die zuvor auf das Stahlflachprodukt aufgebrachte Al-Schicht aufgetragen werden.

Besonders gute Beschichtungserfolge lassen sich darüber hinaus dadurch erzielen, wenn der Zn-Überzug alternativ zu einem Feuerverzinken elektrolytisch auf dem Al-Überzug abgeschieden wird. Beim elektrolytischen Verzinken wird bevorzugt eine Schicht mit einem Zn-Gehalt von mindestens 99 Gew.-% abgeschieden.

Eine weitere alternative Möglichkeit des Auftrags der Zn-Schicht besteht darin, dass der Zn-Überzug in einem PVD-Verfahren auf dem Al-Überzug abgeschieden wird. Die Nutzung des PVD-Verfahrens (PVD = Physical Vapor Deposition) für den Auftrag der Zn-Schicht erlaubt eine besonders exakte Einstellung der Schichtdicke.

Insbesondere in den Fällen, bei denen die Zn-Schicht durch Feuerverzinken und mittels PVD-Verfahren aufgebracht wird, können neben Zn mindestens ein weiteres Element aus Al, Mg oder Fe enthalten sein. Vorteilhafterweise sollten die Gehalte 5 Gew.-% Al, 5 Gew.-% Mg und/oder 0,5 Gew.-% Si nicht überschreiten.

Die Gehalte an weiteren Begleitelementen im Zn-Überzug, wie z.B. Pb, Bi, Cd, Ti, Cu, Cr oder Ni, sollten in Summe 1 Gew.-% nicht überschreiten.

Die im Arbeitsschritt c) erfindungsgemäß auf die Zn-Schicht aufgebrachte, mindestens ein Metallphosphat aufweisende Deckschicht kann durch Spritz- oder Tauchauftrag (z. B. ausgeführt als Bi- oder Tri-Kationenphosphatierung) appliziert werden.

Alternativ ist es auch möglich, die Deckschicht mittels eines No-Rinse-Verfahrens auf die Zn-Schicht aufzubringen. Im Zuge dieses Verfahrens werden in einer ersten Stufe die Metalloberflächen gereinigt. Eventuelle Rückstände von Chemikalien aus dieser ersten Stufe werden anschließend durch Spülen mit Wasser beseitigt. Die so gesäuberte Metalloberfläche wird mit einer vorwiegend wässrigen Lösung benetzt, die jedoch nicht mehr abgespült wird, sondern in situ auf der Metalloberfläche getrocknet und dort zu einem Feststofffilm der Badbestandteile der vorwiegend wässrigen Lösung umgewandelt wird. Zur Erzeugung der erfindungsgemäßen Deckschicht kann ein solches No-Rinse-Verfahren auf Phosphatbasis, mit einem organischen Anteil oder auf silikatischer Basis durchgeführt werden.

Ebenso ist es möglich, die Deckschicht aus der Dampfphase abzuscheiden oder mittels eines Gel/Solnebels zu applizieren. Im Zuge dieser Verfahren werden amorphe und / oder kristalline Phasen auf dem Zn-Überzug abgeschieden.

Besonders praxisgerecht erzeugen lässt sich die erfindungsgemäß phosphathaltige Deckschicht auf dem Zn-Überzug auch dadurch, dass eine entsprechende Phosphatbehandlung innerhalb einer elektrolytischen Beschichtungslinie durchgeführt wird, innerhalb der zuvor bereits die Zn-Schicht auf die Al-basierte Grundschicht des erfindungsgemäß erzeugten Überzugs aufgebracht worden ist.

Zur Einstellung einer die Benetzbarkeit und Anbindung der anschließend aufgetragenen Zn-Schicht verbessernden Oberflächenrauhigkeit kann es zweckmäßig sein, das mit dem Al-Überzug versehene Stahlflachprodukt vor dem Auftrag des Zn-Überzugs einem Dressierwalzen zu unterziehen.

Für denselben Zweck kann es vorteilhaft sein, das mit dem Al-Überzug versehene Stahlflachprodukt vor dem Auftrag des Zn-Überzugs zu dekapieren. Beim Dekapieren werden die erfindungsgemäß beschichteten Flachprodukte durch ein Säurebad geleitet, das die Oxidschicht von ihnen abspült, ohne die Oberfläche des Stahlflachprodukts selbst anzugreifen. Durch den gezielt durchgeführten Schritt der Dekapierung wird der Oxidabtrag so gesteuert, dass man eine für die elektrolytische Bandverzinkung günstig eingestellte Oberfläche erhält.

In manchen Fällen, insbesondere bei einer nicht kontinuierlichen Durchführung der Verfahrensschritte, ist es vorteilhaft, zusätzlich vor dem Dekapieren eine alkalische Reinigung durchzuführen.

Besonders wirtschaftlich lässt sich das erfindungsgemäße Verfahren dann durchführen, wenn der Al-Überzug, anschließend der Zn-Überzug und dann die metallphosphathaltige Deckschicht sowie alle zwischen den jeweiligen Beschichtungsschritten erforderlichen Arbeitsschritte in einer kontinuierlich aufeinand folgend durchlaufenen Arbeitsfolge absolviert werden. Ein typischer Ablauf einer solchen in-line-Erzeugung des Überzugs umfasst dann folgende Arbeitsschritte:
- Reinigung des Stahlsubstrats,
- Glühen des gereinigten Stahlsubstrats,
- Schmelztauchbeschichten des Stahlsubstrats mit der Al-Schicht (Grundschicht, Arbeitsschritt a)),
- Dressierwalzen des mit der Al-Grundschicht beschichteten Stahlflachprodukts,
- Dekapieren des dressiergewalzten Stahlflachproduktes,
- Elektrolytisches Beschichten des dekapierten Stahlflachproduktes mit der Zn-Schicht (Zwischenschicht, Arbeitsschritt b)),
- Auftrag und Formierung der metallphosphathaltigen Deckschicht auf die Zn-Schicht im Zuge einer Phosphatierbehandlung, die in der elektrolytischen Beschichtungslinie durchgeführt wird.

Steht eine entsprechende Anlagentechnik nicht zur Verfügung oder erweist es sich aus sonstigen Gründen als zweckmäßig, so ist es jedoch auch problemlos möglich, den Al-Überzug und anschließend den Zn-Überzug in einer gebrochenen, diskontinuierlichen Arbeitsweise aufzubringen.

Der besondere Vorteil der Erfindung besteht, wie bereits erläutert, darin, dass die Umformung des Stahlflachprodukts zu dem Stahlbauteil in einem einzigen Warmformschritt erfolgen kann. So erweist sich erfindungsgemäß beschichtetes Stahlband als besonders unempfindlich gegen die bei der Warmumformung in einem Zuge auftretenden Belastungen auch dann, wenn das jeweilige Bauteil eine komplexe Form erhält.

Genauso ist es jedoch auch möglich, die Umformung des erfindungsgemäß beschichteten Flachprodukts mehrstufig durchzuführen, wobei jeweils mindestens eine Umformstufe als auf die Erwärmung auf Warmformtemperatur folgender Warmformschritt ausgeführt wird. Dementsprechend kann, wenn sich dies aus produktionstechnischer Sicht als vorteilhaft erweist, das Stahlflachprodukt vor der Erwärmung auf die Warmformtemperatur mindestens einen Kaltumformschritt durchlaufen. Dabei kann die Verformung fast vollständig bei der Kaltumformung erfolgen, so dass in diesem Fall der nach der Kaltverformung durchgeführte Warmformschritt eher ein Warmkalibrieren mit anschließendem Abschrecken im Werkzeug darstellt.

Besonders gute Arbeitsergebnisse stellen sich ein, wenn der Auftrag der einzelnen Schichten des erfindungsgemäß erzeugten Überzugs so durchgeführt wird, dass vor der Wärmebehandlung der auf das Stahlflachprodukt aufgetragene Al-Überzug eine Dicke von 5 - 30 µm, insbesondere von 10 - 30 µm, der auf den AlSi-Überzug aufgetragene Zn-Überzug eine Dicke von 2 - 10 µm und die metallphosphathaltige, auf der Zn-Schicht aufliegende Deckschicht ein Auflagengewicht von 50 mg/m² bis 5 g/m², insbesondere 0,2 - 2 g/m², aufweist.

Dabei haben Untersuchungen ergeben, dass insbesondere dann, wenn der AlSi-Überzug durch Feueraluminieren aufgetragen wird, vor der Erwärmung auf die Wärmebehandlungstemperatur zwischen dem Stahlflachprodukt und dem entsprechend aufgetragenen AlSi-Überzug eine 2 - 10 µm, insbesondere 2 - 5 µm dicke, Al, Si und Fe enthaltende Legierungsgrenzschicht vorhanden ist, auf der eine 5 - 20 µm dicke AlSi-haltige Schicht liegt. Unter Berücksichtigung der voranstehend genannten Dicken seiner einzelnen Schichten weist eine erfindungsgemäß in mindestens drei Arbeitsgängen auf das zu verformende Flachprodukt aufgebrachte metallische Beschichtung typischerweise eine Gesamtdicke von 5 - 100 µm, insbesondere 15 - 70 µm, auf.

Am Ende der Wärmebehandlung, d. h. beim Eintritt in das jeweilige Warmformwerkzeug, liegt dann auf einem erfindungsgemäß überzogenen Stahlflachprodukt ein Überzug vor, der aus einer 10 - 35 µm dicken Grundschicht, einer darauf liegenden, 3 - 10 µm dicken Zwischenschicht und einer 0,01 - 10 µm, insbesondere 0,01 - 3 µm, dicken Deckschicht zusammengesetzt ist.

Nachfolgend wird die Erfindung anhand eines Ausführungsbeispiels näher erläutert.

Aus einem härtbaren Stahl, beispielsweise aus dem bekannten 22MnB5-Stahl, ist in an sich bekannter Weise durch Vergießen einer entsprechend zusammengesetzten Stahlschmelze zu einer Bramme oder Dünnbramme, Warmwalzen der jeweiligen Bramme zu einem Warmband, Haspeln des Warmbands und Kaltwalzen des Warmbands in konventioneller Weise ein kaltgewalztes Stahlband erzeugt worden, wobei zusätzlich zu den voranstehend genannten Arbeitsschritten erforderlichenfalls zusätzliche Arbeitsschritte, wie ein Glühen und Beizen des nach dem Warmwalzen erhaltenen Warmbandes oder Glühen des Kaltbandes, durchgeführt worden sind.

Das so erhaltene kaltgewalzte Stahlband ist in eine kontinuierlich arbeitende Schmelztauchbeschichtungslinie eingespeist worden, deren einzelne Arbeitsstationen es in einer kontinuierlichen Abfolge aufeinanderfolgend durchlaufen hat. In der Schmelztauchbeschichtungslinie ist das kaltgewalzte Stahlband zunächst in einem Reinigungsteil von den aus dem Kaltwalzprozess auf ihm verbliebenen Schmutzrückständen befreit worden. Dann hat das gereinigte Stahlband einen Glühofen durchlaufen, in dem es auf 750°C erwärmt und unter einer zu 10 Vol.-% aus H2, Rest N2 bestehenden Schutzgasatmosphäre rekristallisierend geglüht worden ist. Noch unter der Schutzgasatmosphäre ist das geglühte Stahlband dann auf eine Temperatur von 680 °C abgekühlt worden und in ein Aluminiumbad eingetaucht worden, dessen Badtemperatur 660°C betrug. Neben Al und unvermeidbaren Verunreinigungen enthielt das Bad 10% Silizium.

Nach dem Herausziehen des Stahlbandes aus dem Schmelzbad ist mittels eines Düsenabstreifsystems die Dicke der nun auf dem Stahlband vorhandenen AlSi-Überzugsschicht auf 20 µm eingestellt worden, die die Grundschicht des auf dem Stahlband zu erzeugenden Überzugs bildet.

Anschließend ist das mit der AlSi-Überzugsschicht versehene Stahlband auf weniger als 50 °C abgekühlt worden.

Das abgekühlte Stahlband ist dann einem Dressierwalzen unterzogen worden, um die Oberflächenrauheit der AlSi-Überzugsschicht einzustellen.

In einem folgenden Abschnitt ist das dressiergewalzte Stahlband einer Dekapierbehandlung unterzogen worden, bei der es zunächst alkalisch mit NaOH vorbehandelt und daraufhin in einer wässrigen Lösung mit 80 g/l HCl für 5 s bei 40 °C von den auf ihm haftenden oxidischen Rückständen befreit worden ist. Anschließend ist das Band mit vollentsalztem Wasser gespült worden.

Danach erfolgt in Elektrolysezellen die elektrolytische Abscheidung von einer 5 µm dicken, die Zwischenschicht des zu erzeugenden Überzuges bildenden Zinkschicht aus einem Zinksulfat-Elektrolyten bei einer Stromdichte von 50 A/m² und einer Elektrolyttemperatur von 60°C auf der Oberfläche der zuvor erzeugten Al-Überzugschicht.

In einem weiteren Verfahrensschritt ist dann mittels Spritzapplikation eine 50 °C warme Phosphatlösung mit den Hauptkationen Zn, Mn und Ni auf die Zn-Überzugsschicht appliziert worden. Aus diesem Auftrag resultierten anorganische Konversionsschichten mit einem Schichtgewicht von 0,5g/m², die die Deckschicht des zu erzeugenden Überzugs bildeten.

Für den Weitertransport zur nachfolgende durchlaufenen Warmformgebungslinie ist das so mit einem mindestens dreischichtigen Überzug versehene Band zu einem Coil aufgehaspelt worden.

Am Beginn der Warmformgebungslinie sind aus dem beschichteten Stahlband zunächst Platinen geschnitten worden.

In einem einstufig durchgeführten Vorgang, in dem eine Wärmebehandlung des Überzugs in Kombination mit der Erwärmung auf die für die Warmumformung der Platine erforderliche Temperatur erfolgte, sind die Platinen anschließend in einem Ofen erwärmt und für fünf Minuten bei dieser Temperatur gehalten worden. Die Temperatur der Wärmebehandlung und die für das Warmformen erforderliche Warmformtemperatur waren gleich und betrugen jeweils 880 °C. Die Dauer der Wärmebehandlung war so bemessen, dass die Stahlplatine am Ende der Wärmebehandlung auf die Warmformtemperatur durcherwärmt war.

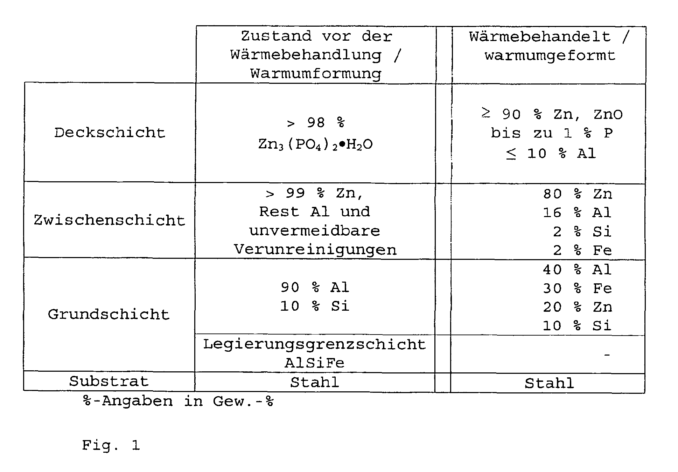

Die Figur zeigt einen Vergleich des Schichtaufbaus des auf dem in der voranstehend beschriebenen Weise beschichteten Stahlflachprodukt erzeugten Überzugs vor und nach der Wärmebehandlung.

Die aus dem Ofen austretenden Platinen sind mittels eines Manipulators in eine Warmumformpresse überführt, in der sie in an sich bekannter Weise zu einem Stahlbauteil warmpressgeformt worden sind. Die erhaltenen Stahlbauteile sind dann so schnell abgekühlt worden, dass sich Härtegefüge eingestellt hat und die erforderlichen Festigkeitswerte erreicht worden sind.

## Patentansprüche

1. Verfahren zum Herstellen eines mit einem metallischen, vor Korrosion schützenden Überzug versehenen Stahlbauteils, umfassend folgende Arbeitsschritte:
a) Beschichten eines aus einem legierten Vergütungsstahl erzeugten Stahlflachprodukts mit einem Al-Überzug, der mindestens 85 Gew.-% Al und optional bis zu 15 Gew.-% Si enthält;
b) Beschichten des mit dem Al-Überzug versehenen Stahlflachproduktes mit einem Zn-Überzug, der mindestens 90 Gew.-% Zn enthält,
c) Beschichten des mit dem Al-Überzug und dem darauf liegenden Zn-Überzug versehenen Stahlflachproduktes mit einer Deckschicht, deren Hauptbestandteil mindestens ein metallisches Salz der Phosphorsäure oder der Diphosphorsäure ist und die zusätzlich Gehalte von bis zu 45 % eines Verhältnisses Al:Zn, wobei Al an diesem Verhältnis 0,1 - 99,9 Gew.-% und Zn den jeweiligen Rest einnimmt, oder Verbindungen von Al und Zn sowie wahlweise Metalloxide, Metallhydroxide und/oder Schwefelverbindungen enthalten kann,
d) Wärmebehandeln des Stahlflachproduktes bei einer Wärmebehandlungstemperatur, die mindestens 750 °C beträgt,
e) Erwärmen des Stahlflachproduktes auf eine Warmformtemperatur,
f) Warmformen des Stahlbauteils aus dem erwärmten Stahlflachprodukt, und
g) Abkühlen des warmgeformten Stahlbauteils mit einer Abkühlgeschwindigkeit, die zur Ausbildung von Vergütungs- oder Härtegefüge ausreicht.

2. Verfahren nach Anspruch 1, **dadurch gekennzeichnet, dass** die Wärmebehandlung (Arbeitsschritt d)) und die Erwärmung des Stahlflachproduktes auf die Warmformtemperatur (Arbeitsschritt e)) in einem gemeinsamen Arbeitsschritt durchgeführt werden.

3. Verfahren nach Anspruch 2, **dadurch gekennzeichnet, dass** die Wärmebehandlungstemperatur höchstens gleich der Warmformtemperatur ist.

4. Verfahren nach einem der voranstehenden Ansprüche, **dadurch gekennzeichnet, dass** die Wärmebehandlungstemperatur im Bereich von 800 - 950 °C, insbesondere 800 - 910 °C, liegt.

5. Verfahren nach einem der voranstehenden Ansprüche, **dadurch gekennzeichnet, dass** die Warmformtemperatur im Bereich von 800 - 950 °C, insbesondere 800 - 910 °C liegt.

6. Verfahren nach einem der voranstehenden Ansprüche, **dadurch gekennzeichnet, dass** der Al-Überzug durch Feueraluminieren aufgebracht wird.

7. Verfahren nach einem der voranstehenden Ansprüche, **dadurch gekennzeichnet, dass** der Al-Überzug 5 - 12 Gew.-% Si enthält.

8. Verfahren nach einem der voranstehenden Ansprüche, **dadurch gekennzeichnet, dass** der auf das Stahlflachprodukt aufgetragene Al-Überzug vor der Erwärmung auf die Warmformtemperatur eine Dicke von 5 - 25 µm aufweist.

9. Verfahren nach einem der voranstehenden Ansprüche, **dadurch gekennzeichnet, dass** der Zn-Überzug durch ein Feuerverzinken auf die zuvor auf das Stahlflachprodukt aufgebrachte Al-Schicht aufgetragen wird.

10. Verfahren nach einem der Ansprüche 1 bis 8, **dadurch gekennzeichnet, dass** der Zn-Überzug elektrolytisch auf dem Al-Überzug abgeschieden wird.

11. Verfahren nach einem der Ansprüche 1 bis 8, **dadurch gekennzeichnet, dass** der Zn-Überzug in einem PVD-Verfahren auf dem Al-Überzug abgeschieden wird.

12. Verfahren nach einem der voranstehenden Ansprüche, **dadurch gekennzeichnet, dass** der Zn-Überzug mindestens 85 Gew.-% Zn enthält.

13. Verfahren nach einem der voranstehenden Ansprüche, **dadurch gekennzeichnet, dass** im Zn-Überzug neben Zn mindestens ein Element aus der Gruppe "Al, Mg, Ni, Si" enthalten ist.

14. Verfahren nach einem der voranstehenden Ansprüche, **dadurch gekennzeichnet, dass** der auf den Al-Überzug aufgetragene Zn-Überzug vor der Erwärmung auf die Warmformtemperatur eine Dicke von 2 - 10 µm aufweist.

15. Verfahren nach einem der voranstehenden Ansprüche, **dadurch gekennzeichnet, dass** zwischen dem Stahlflachprodukt und dem Al-Überzug vor der Erwärmung auf die Warmformtemperatur eine 2 - 5 µm dicke, Al, Si und Fe enthaltende Legierungsgrenzschicht vorhanden ist.

16. Verfahren nach einem der voranstehenden Ansprüche, **dadurch gekennzeichnet, dass** die auf die Zn-Schicht aufgetragene Deckschicht vor dem Erwärmen auf die Wärmebehandlungstemperatur mindestens ein mit einem Metall aus der Gruppe "Cu, Mo, Fe, Mn, Sb, Zn, Ti, Ni, Co, V, Mg, Bi, Be, Al, Ce, Ba, Sr, Na, K, Ge, Ga, Ca, Cr, In oder Sn", insbesondere aus der Gruppe "Zn, Fe, Ni, Mo, Mn", gebildetes Metallphosphat enthält.

17. Verfahren nach einem der voranstehenden Ansprüche, **dadurch gekennzeichnet, dass** die Deckschicht durch Spritzen, durch Tauchen, in einem No-Rinse-Verfahren, durch elektrolytisches Abscheiden oder durch Abscheidung aus der Dampfphase auf die Zn-Schicht aufgetragen wird.

18. Verfahren nach einem der voranstehenden Ansprüche, **dadurch gekennzeichnet, dass** die Gesamtdicke der auf dem Stahlflachprodukt vor der Erwärmung auf die Warmformtemperatur vorhandenen metallischen Beschichtung 7 - 35 µm beträgt.

19. Verfahren nach einem der voranstehenden Ansprüche, **dadurch gekennzeichnet, dass** das fertig geformte Stahlbauteil eine unmittelbar auf dem Stahlflachprodukt, aus dem das Stahlbauteil geformt ist, aufliegende zum überwiegenden Teil aus Al und zusätzlichen Gehalten an Fe, Zn und Si bestehende Grundschicht, eine auf der Grundschicht aufliegende, zum überwiegenden Teil aus Zn und zusätzlichen Gehalten aus Al, Si und Fe bestehende Zwischenschicht und eine Deckschicht aufweist, die im Wesentlichen aus amorphen Phosphaten oder deren thermischen Spaltprodukten besteht, wobei 0,1 - 45 Gew.-% Zn in der vom Stahlflachprodukt abgewandten Oberfläche sowie kristalline Restanteile an Phosphaten enthalten sind.

20. Verfahren nach Anspruch 19, **dadurch gekennzeichnet, dass** die Grundschicht mindestens 30 Gew.-% Al, mindestens 20 Gew.-% Fe und mindestens 3 Gew.-% Si aufweist.

21. Verfahren nach einem der Ansprüche 19 oder 20, **dadurch gekennzeichnet, dass** die Zwischenschicht mindestens 60 Gew.-% Zn, mindestens 5 Gew.-% Al sowie bis zu 10 Gew.-% Fe und bis zu 10 Gew.-% Si aufweist.

22. Verfahren nach einem der Ansprüche 19 bis 21, **dadurch gekennzeichnet, dass** die Deckschicht überwiegend aus amorphen und kristallinen Diphosphaten und Zink- und/oder Aluminiumoxid besteht.

23. Verfahren nach einem der Ansprüche 19 - 22, **dadurch gekennzeichnet, dass** die Dicke der Grundschicht 15 - 35 µm, die Dicke der Zwischenschicht 3 - 10 µm und die Dicke der Deckschicht 0,01 - 10 µm beträgt.

24. Verfahren nach einem der voranstehenden Ansprüche, **dadurch gekennzeichnet, dass** das Stahlflachprodukt aus einem Mangan-Bor-Stahl erzeugt ist.

25. Stahlbauteil hergestellt durch ein mindestens einen Warmumformschritt umfassendes Umformen eines aus einem legierten Vergütungsstahl erzeugten, mit einer vor Korrosion schützenden metallischen Beschichtung beschichteten Stahlflachprodukts, **dadurch gekennzeichnet, dass** die metallische Beschichtung durch eine auf dem Stahlflachprodukt aufliegende Grundschicht, eine auf der Grundschicht liegende Zwischenschicht und eine auf der Zwischenschicht liegende Deckschicht gebildet ist, **dass** die Grundschicht mindestens 30 Gew.-% Al, mindestens 20 Gew.-% Fe, mindestens 3 Gew.-% Si und höchstens 30 Gew.-% Zn enthält, d a s s die Zwischenschicht mindestens 60 Gew.-% Zn, mindestens 5 Gew.-% Al, bis zu 10 Gew.-% Fe und bis zu 10 Gew.-% Si und d a s s die Deckschicht mindestens 8 Gew.-% Zn sowie ZnO, P und Al enthält, wobei der P-Gehalt höchstens 1 Gew.-% aufweist und der Hauptbestandteil der Deckschicht ZnO ist.

26. Stahlbauteil nach Anspruch 25, **dadurch gekennzeichnet, dass** die Dicke der Grundschicht 10 - 50 µm, insbesondere 15 - 35 µm, die Dicke der Zwischenschicht 5 - 20 µm, insbesondere 3 - 10 µm, und die Dicke der Deckschicht 0,01 - 10 µm, insbesondere 0,01 - 3 µm, beträgt.

## Claims

1. Method for producing a steel component provided with a metallic coating which protects against corrosion, comprising the following production steps:
a) Coating a steel flat product, produced from an alloyed heat-treated steel, with an Al coating which contains at least 85 %wt. Al and optionally up to 15 % wt. Si,
b) Coating the steel flat product provided with the Al coating with a Zn coating which contains at least 90 % wt. Zn,
c) Coating the steel flat product, provided with the Al coating and the Zn coating lying on it, with a top layer, the main constituent of which is at least one metal salt of phosphoric acid or diphosphoric acid, and which additionally can contain contents of up to 45 % of an Al:Zn ratio, wherein Al takes up 0.1 - 99.9 % wt. of this ratio and Zn the respective remaining amount, or compounds of Al and Zn, as well as optionally metal oxides, metal hydroxides and/or sulphur compounds,
d) Heat treating the steel flat product at a heat-treating temperature which is at least 750 °C,
e) Heating the steel flat product to a hot-forming temperature,
f) Hot forming the steel component made from the heated steel flat product and
g) Cooling the hot-formed steel component at a cooling rate which is sufficient to form a tempered or martensitic structure.

2. Method according to Claim 1, **characterised in that** the heat treatment (production step d)) and the heating of the steel flat product to the hot-forming temperature (production step e)) are carried out in a common production step.

3. Method according to Claim 2, **characterised in that** the heat-treatment temperature is at most equal to the hot-forming temperature.

4. Method according to any one of the preceding claims, **characterised in that** the heat-treatment temperature is in the range from 800 - 950 °C, in particular 800 - 910 °C.

5. Method according to any one of the preceding claims, **characterised in that** the hot-forming temperature is in the range from 800 - 950 °C, in particular 800 - 910 °C.

6. Method according to any one of the preceding claims, **characterised in that** the Al coating is applied by hot-dip aluminizing.

7. Method according to any one of the preceding claims, **characterised in that** the Al coating contains 5 - 12 % wt. Si.

8. Method according to any one of the preceding claims, **characterised in that** before heating to the hot-forming temperature the Al coating applied onto the steel flat product has a thickness of 5 - 25 µm.

9. Method according to any one of the preceding claims, **characterised in that** the Zn coating is applied by hot-dip galvanizing onto the Al layer which was previously applied onto the steel flat product.

10. Method according to any one of Claims 1 to 8, **characterised in that** the Zn coating is deposited on the Al coating electrolytically.

11. Method according to any one of Claims 1 to 8, **characterised in that** the Zn coating is deposited on the Al coating in a PVD process.

12. Method according to any one of the preceding claims, **characterised in that** the Zn coating contains at least 85 % wt. Zn.

13. Method according to any one of the preceding claims, **characterised in that** besides Zn at least one element from the group "Al, Mg, Ni, Si" is contained in the Zn coating.

14. Method according to any one of the preceding claims, **characterised in that** before heating to the hot-forming temperature the Zn coating applied onto the Al coating has a thickness of 2 - 10 µm.

15. Method according to any one of the preceding claims, **characterised in that** before heating to the hot-forming temperature a 2 - 5 µm thick alloy barrier layer containing Al, Si and Fe is present between the steel flat product and the Al coating.

16. Method according to any one of the preceding claims, **characterised in that** before heating to the heat-treatment temperature the top layer applied onto the Zn layer contains at least one metal phosphate formed by a metal from the group "Cu, Mo, Fe, Mn, Sb, Zn, Ti, Ni, Co, V, Mg, Bi, Be, Al, Ce, Ba, Sr, Na, K, Ge, Ga, Ca, Cr, In or Sn", in particular from the group "Zn, Fe, Ni, Mo, Mn".

17. Method according to any one of the preceding claims, **characterised in that** the top layer is applied onto the Zn layer by spraying, by dipping, in a no-rinse process, by electrolytic deposition or by vapour deposition.

18. Method according to any one of the preceding claims, **characterised in that** the total thickness of the metallic coating present on the steel flat product before heating to the hot-forming temperature is 7 - 35 µm.

19. Method according to any one of the preceding claims, **characterised in that** the finish-formed steel component has a base layer, lying directly on the steel flat product, from which the steel component is formed, and predominantly consisting of Al and additional contents of Fe, Zn and Si, an intermediate layer, lying on the base layer and predominantly consisting of Zn and additional contents of Al, Si and Fe, and a top layer which essentially exists of amorphous phosphates or the thermal decomposition products thereof, wherein 0.1 - 45 % wt. Zn is contained in the surface remote from the steel flat product, as well as crystalline residual amounts of phosphates.

20. Method according to Claim 19, **characterised in that** the base layer has at least 30 % wt. Al, at least 20 % wt. Fe and at least 3 % wt. Si.

21. Method according to either of Claims 19 and 20, **characterised in that** the intermediate layer has at least 60 % wt. Zn, at least 5 % wt. Al, as well as up to 10 % wt. Fe and up to 10 % wt. Si.

22. Method according to any one of Claims 19 to 21, **characterised in that** the top layer predominantly consists of amorphous and crystalline diphosphates and zinc oxide and/or aluminium oxide.

23. Method according to any one of Claims 19 to 22, **characterised in that** the thickness of the base layer is 15 - 35 µm, the thickness of the intermediate layer is 3 - 10 µm and the thickness of the top layer is 0.01 - 10 µm.

24. Method according to any one of the preceding claims, **characterised in that** the steel flat product is produced from a manganese boron steel.

25. Steel component produced by forming - which comprises at least one hot-forming step - a steel flat product produced from an alloyed heat-treated steel and coated with a metallic coating which protects against corrosion, **characterised in that** the metallic coating is formed by a base layer lying on the steel flat product, by an intermediate layer lying on the base layer and by a top layer lying on the intermediate layer, **in that** the base layer contains at least 30 % wt. Al, at least 20 % wt. Fe, at least 3 % wt. Si and at most 30 % wt. Zn, **in that** the intermediate layer contains at least 60 % wt. Zn, at least 5 % wt. Al, up to 10 % wt. Fe and up to 10 % wt. Si, and **in that** the top layer contains at least 8 % wt. Zn, as well as ZnO, P and Al, wherein the P content is at most 1 % wt. and the main constituent of the top layer is ZnO.

26. Steel component according to Claim 25, **characterised in that** the thickness of the base layer is 10 - 50 µm, in particular 15 - 35 µm, the thickness of the intermediate layer is 5 - 20 µm, in particular 3 - 10 µm, and the thickness of the top layer is 0.01 - 10 µm, in particular 0.01 - 3 µm.

## Revendications

1. Procédé de fabrication d'une pièce de structure en acier dotée d'un revêtement métallique protégeant contre la corrosion, ledit procédé comprenant les étapes de travail, qui suivent, consistant à :
a) recouvrir un produit plat en acier produit à partir d'un acier de traitement allié, d'un revêtement en aluminium qui contient au moins 85 % en poids d'aluminium et, de façon optionnelle, jusqu'à 15 % en poids de silicium,
b) recouvrir le produit plat en acier doté du revêtement en aluminium, d'un revêtement en zinc qui contient au moins 90 % en poids de zinc,
c) recouvrir le produit plat en acier doté du revêtement en aluminium et du revêtement en zinc appliqué par-dessus, d'une couche de recouvrement dont le composant principal est au moins un sel métallique de l'acide phosphorique ou de l'acide diphosphorique et qui peut présenter en outre des teneurs allant jusqu'à 45 % d'un rapport Al : Zn, où l'aluminium forme de 0,1 % en poids à 99,9 % en poids de ce rapport, le zinc formant la partie résiduelle respective, ou bien contenir des composés d'aluminium et de zinc ainsi que, au choix, des oxydes métalliques, des hydroxydes métalliques et/ou des composés de soufre,
d) traiter à chaud le produit plat en acier à une température de traitement à chaud qui est au moins de 750°C,
e) chauffer le produit plat en acier à une température de formage à chaud,
f) former à chaud la pièce de structure en acier à partir du produit plat en acier chauffé, et
g) refroidir la pièce de structure en acier formée à chaud, à une vitesse de refroidissement qui est suffisante pour la formation d'une structure de trempe et de revenu ou d'une structure de trempe.

2. Procédé selon la revendication 1, **caractérisé en ce que** le traitement à chaud (étape de travail d)) et le chauffage du produit plat en acier à la température de formage à chaud (étape de travail e)) sont exécutés au cours d'une étape de travail commune.

3. Procédé selon la revendication 2, **caractérisé en ce que** la température de traitement à chaud est au maximum égale à la température de formage à chaud.

4. Procédé selon l'une quelconque des revendications précédentes, **caractérisé en ce que** la température de traitement à chaud se situe dans la plage allant de 800°C à 950°C, en particulier de 800°C à 910°C.

5. Procédé selon l'une quelconque des revendications précédentes, **caractérisé en ce que** la température de formage à chaud se situe dans la plage allant de 800°C à 950°C, en particulier de 800°C à 910°C.

6. Procédé selon l'une quelconque des revendications précédentes, **caractérisé en ce que** le revêtement en aluminium est appliqué par aluminiage au trempé.

7. Procédé selon l'une quelconque des revendications précédentes, **caractérisé en ce que** le revêtement en aluminium contient entre 5 % en poids et 12 % en poids de silicium.

8. Procédé selon l'une quelconque des revendications précédentes, **caractérisé en ce que** le revêtement en aluminium appliqué sur le produit plat en acier présente, avant le chauffage à la température de formage à chaud, une épaisseur comprise entre 5 µm et 25 µm.

9. Procédé selon l'une quelconque des revendications précédentes, **caractérisé en ce que** le revêtement en zinc est appliqué, par une galvanisation à chaud, sur la couche d'aluminium appliquée auparavant sur le produit plat en acier.

10. Procédé selon l'une quelconque des revendications 1 à 8, **caractérisé en ce que** le revêtement en zinc est déposé électrolytiquement sur le revêtement en aluminium.

11. Procédé selon l'une quelconque des revendications 1 à 8, **caractérisé en ce que** le revêtement en zinc est déposé sur le revêtement en aluminium, par un procédé physique de dépôt en phase gazeuse (PVD).

12. Procédé selon l'une quelconque des revendications précédentes, **caractérisé en ce que** le revêtement en zinc contient au moins 85 % en poids de zinc.

13. Procédé selon l'une quelconque des revendications précédentes, **caractérisé en ce qu'**au moins un élément faisant partie du groupe "Al, Mg, Ni, Si" est contenu dans le revêtement en zinc, en plus du zinc.

14. Procédé selon l'une quelconque des revendications précédentes, **caractérisé en ce que** le revêtement en zinc appliqué sur le revêtement en aluminium présente, avant le chauffage à la température de formage à chaud, une épaisseur comprise entre 2 µm et 10 µm.

15. Procédé selon l'une quelconque des revendications précédentes, **caractérisé en ce qu'**une couche de jonction par alliage, d'une épaisseur comprise entre 2 µm et 5 µm et contenant de l'aluminium, du silicium et du fer, est présente, avant le chauffage à la température de formage à chaud, entre le produit plat en acier et le revêtement en aluminium.

16. Procédé selon l'une quelconque des revendications précédentes, **caractérisé en ce que** la couche de recouvrement appliquée sur la couche de zinc contient, avant le chauffage à la température de traitement à chaud, au moins un phosphate de métal formé avec un métal faisant partie du groupe "Cu, Mo, Fe, Mn, Sb, Zn, Ti, Ni, Co, V, Mg, Bi, Be, Al, Ce, Ba, Sr, Na, K, Ge, Ga, Ca, Cr, In ou Sn", en particulier faisant partie du groupe "Zn, Fe, Ni, Mo, Mn".

17. Procédé selon l'une quelconque des revendications précédentes, **caractérisé en ce que** la couche de recouvrement est appliquée sur la couche de zinc, par pulvérisation, par immersion, dans un procédé sans rinçage, par dépôt électrolytique ou par dépôt résultant de la phase vapeur.

18. Procédé selon l'une quelconque des revendications précédentes, **caractérisé en ce que** l'épaisseur totale du revêtement métallique présent sur le produit plat en acier, avant le chauffage à la température de formage à chaud, est comprise entre 7 µm et 35 µm.

19. Procédé selon l'une quelconque des revendications précédentes, **caractérisé en ce que** la pièce de structure en acier formée de façon définitive présente une couche de base qui se trouve directement sur le produit plat en acier à partir duquel est formée la pièce de structure en acier, et se compose en majeure partie d'aluminium et ayant des teneurs supplémentaires en fer, en zinc et en silicium, une couche intermédiaire qui se trouve sur la couche de base et se compose en majeure partie de zinc et ayant des teneurs supplémentaires en aluminium, en silicium et en fer, et une couche de recouvrement qui se compose essentiellement de phosphates amorphes ou de leurs produits de décomposition thermiques, où une quantité comprise entre 0,1 % en poids et 45 % en poids de zinc est contenue dans la surface placée à l'opposé du produit plat en acier, des résidus cristallins de phosphates étant également contenus.

20. Procédé selon la revendication 19, **caractérisé en ce que** la couche de base présente au moins 30 % en poids d'aluminium, au moins 20 % en poids de fer et au moins 3 % en poids de silicium.

21. Procédé selon l'une des revendications 19 ou 20, **caractérisé en ce que** la couche intermédiaire présente au moins 60 % en poids de zinc, au moins 5 % en poids d'aluminium, également jusqu'à 10 % en poids de fer et jusqu'à 10 en poids de silicium.

22. Procédé selon l'une quelconque des revendications 19 à 21, **caractérisé en ce que** la couche de recouvrement se compose principalement de diphosphates amorphes et cristallins et d'oxyde de zinc et/ou d'aluminium.

23. Procédé selon l'une quelconque des revendications 19 à 22, **caractérisé en ce que** l'épaisseur de la couche de base est de 15 µm à µm, l'épaisseur de la couche intermédiaire de 3 µm à 10 µm et l'épaisseur de la couche de recouvrement de 0,01 µm à 10 µm.

24. Procédé selon l'une quelconque des revendications précédentes, **caractérisé en ce que** le produit plat en acier est réalisé à partir d'un acier à base de manganèse et de bore.

25. Pièce de structure en acier fabriquée par une transformation, comprenant au moins une étape de transformation à chaud d'un produit plat en acier réalisé à partir d'un acier de traitement allié et recouvert d'un revêtement métallique protégeant contre la corrosion,
**caractérisée en ce que** le revêtement métallique est formé par une couche de base appliquée sur le produit plat en acier, par une couche intermédiaire se trouvant sur la couche de base et par une couche de recouvrement se trouvant sur la couche intermédiaire, **en ce que** la couche de base contient au moins 30 % en poids d'aluminium, au moins 20 % en poids de fer, au moins 3 % en poids de silicium et au maximum 30 % en poids de zinc, **en ce que** la couche intermédiaire contient au moins 60 % en poids de zinc, au moins 5 % en poids d'aluminium, jusqu'à 10 % en poids de fer et jusqu'à 10 % en poids de silicium, et **en ce que** la couche de recouvrement contient au moins 8 % en poids de zinc ainsi que de l'oxyde de zinc (ZnO), du phosphore et de l'aluminium, où la teneur en phosphore est au maximum de 1 % en poids, et le composant principal de la couche de recouvrement est de l'oxyde de zinc (ZnO).

26. Pièce de structure en acier selon la revendication 25, **caractérisée en ce que** l'épaisseur de la couche de base est de 10 µm à µm, en particulier de 15 µm à 35 µm, l'épaisseur de la couche intermédiaire de 5 µm à 20 µm, en particulier de 3 µm à 10 µm, et l'épaisseur de la couche de recouvrement de 0,01 µm à 10 µm, en particulier de 0,01 µm à 3 µm.
